# EUROPEAN PATENT APPLICATION

(11) **EP 4 644 869 A1**
(43) Date of publication of application: **05.11.2025**
(21) Application number: 24199315.3
(22) Date of filing: 09.09.2024
(51) Int. Cl.: G01N 21/39, G01J 3/42, H01L 21/673, G01N 1/24, G01N 21/94

(54) **METHOD AND SYSTEM FOR DETERMINING A CONCENTRATION OF AT LEAST ONE COMPONENT OF A GAS IN A CONTAINER**

(30) Priority: 30.04.2024 EP 24173384
(71) Applicant: Brooks Automation (Germany) GmbH, 78256 Steißlingen (DE)
(72) Inventor: LI, Fan, 78267 Aach (DE); DOGAN, Ali Caner, 71706 Markgröningen (DE)
(74) Representative: Dehns Germany Partnerschaft mbB

(57) **Abstract**

The invention relates to a method for determining a concentration of at least one component of a gas in a container (210) adapted and configured to hold wafers or reticles, comprising the steps of: transferring an amount of gas from the container (210) to a non-destructive gas analysing unit (220); determining a concentration of the amount of gas by means of the non-destructive gas analysing unit (220); and returning the amount of gas from the non-destructive gas analysing unit (220) to the container (210).

## Description

The present invention relates to a method and to a system for determining a concentration of at least one component of a gas in a container adapted and configured to hold wafers or reticles as well as to a use of a non-destructive gas analysing unit for such a system.

### Background of the invention

Reticles are photomasks used for the production of integrated circuits, so called chips, to produce patterns on thin wafers of material, usually silicon.

Cleanliness requirements within the semiconductor industry has become ever more important, especially in connection EUV technology. In order to obtain a reasonable yield of chips, the entire fabrication and handling environment for reticles and semiconductor wafers, sometimes referred to as semiconductor ecosystem, needs to work at extreme levels of efficiency and cleanliness with almost no scope for error. This requirement necessitates monitoring every aspect of the semiconductor ecosystem, irrespective of it belonging to manufacturing, process control or R&D. Every piece of information thus generated and stored can prove invaluable.

Contamination control plays an especially crucial role, as this directly influences cleanliness of wafers. Wafers are typically transported in specialized containers, so called FOUPs (Front Opening Unified Pods), and the environment within these containers, often referred to as mini environment, is critical, as it directly impacts wafer or chip yield. This chip yield can be significantly enhanced by appropriate contamination control.

In semiconductor manufacturing, the trend towards smaller features - approaching that of atomic-scale - has brought with it new challenges. One is the challenge of controlling airborne molecular contaminants (AMC). AMC come from both internal processes such as chemicals and materials used in the manufacturing of containers and external processes, such as the air supply within semiconductor fabs. The presence of AMC even at very low concentrations can lead to costly defects in the wafers or reticles. Water vapor or moisture within containers is also to be avoided. Moisture is can induce various chemical reactions that subsequently lead to defects. Currently, moisture contamination control is adopted in many wafer handling and storage situations. Particles, AMC, oxygen, and moisture have the potential to cause defects on reticles or wafers which can lead to reduced product performance or product yield in manufacturing processes. All these items as well as their components are to be considered as gases (or components of gases), whose concentration within a container is to be determined according to the invention. At the same time, the invention is not limited to determining the concentration of these gases, the invention is also applicable to any other gas, item or component potentially present within such containers.

FOUPs are typically made of polycarbonate material, which is a hygroscopic polymer that can retain moisture. This means that cleaning fluids such as deionised water can be absorbed during the cleaning process. On the other hand, subsequent purging, for example using clean dry air (CDA), can induce desorption of moisture from the FOUP material. Hereafter, it must be ensured that FOUPs thus cleaned are completely free of moisture before usage. The capability of a FOUP to retain moisture can change over time, giving an indication of its age and condition.

Reticles, for which similar if not even more stringent cleanliness requirements apply, are usually transported and stored in so called reticle pods. Reticle pods and FOUPS will be at times simply referred to as 'pods' or containers in the following.

It is therefore desirable to determine a gas concentration inside a container, e.g. in order to recognise and/or monitor contamination within the container.

### Disclosure of the invention

The present invention refers to a method and to a system for determining a concentration of at least one component of a gas in a container adapted and configured to hold wafers or reticles, as well as to the use of a non-destructive gas analysing unit for such a system with the features as set out in the independent claims. Advantageous embodiments are the subject-matter of the dependent claims as well as the following description. Determining the concentration of at least one component of a gas especially comprises determining the concentration of a gas as a whole. For example, if the gas as a whole were to comprise more than one of the items which may be present in such a container, such as particles, AMC, moisture and oxygen, these items thus constituting the various components of the gas, either the concentration of the gas a whole, or the concentration of at least one of the components can be determined. Be it noted that the terms "determining the concentration of a gas" and "determining the concentration of at least one component of a gas" are used simultaneously and separately in this specification. When one of the terms is used by itself, it is to be assumed that the respective passage is meant to cover the other term as well. The same holds for the wording "a gas and/or its components", which is also occasionally used.

Depending on circumstances, the term "gas concentration" could be expressed as parts per reference number, such as parts per million (ppm), or as parts per volume unit, or as mass concentration, i.e. mass per volume unit, for example microgram or milligram per cubic metre. The term gas concentration may also refer to a relative gas concentration of a first gas component to any other gas component.

The invention is particularly suitable for a variety of different wafer or reticle containers such as a front opening unified pod (FOUP), a front opening shipping box (FOSB), a standard mechanical interface (SMIF), a reticle SMIF pod (RSP), etc.

According to the invention, an amount of gas or a gas sample is transferred from the container to a non-destructive gas analysing unit. A concentration of at least one component of the amount of gas is determined by means of the non-destructive gas analysing unit. After this determination of the concentration of at least one component of the amount of gas, the amount of the gas is returned from the non-destructive gas analysing unit back to the container.

The term non-destructive gas analysing unit is particularly to be understood as a unit which can analyse the amount of gas without changing or amending physical and/or chemical properties of the gas, particularly without changing or amending the concentration of the components of the gas and of the gas itself. The invention therefore allows to determine the concentration of a gas and/or its components within the container without changing the gas concentration itself.

The non-destructive gas analysing unit is particularly provided as a spectroscopy unit, wherein a radiation, e.g. light, can be emitted towards the amount of gas. The amount of gas can especially interact with the radiation in a specific manner, e.g. absorb or scatter the radiation, depending on the specific concentration of the gas. Thus, by analysing how the gas interacts with the radiation, the specific concentration of the gas can be determined. As the concentration of the gas and/or that of its components is not altered by means of the respective radiation, the measurement by means of the spectroscopy unit is repeatable.

The non-destructive gas analysing unit can for example be provided as direct absorption spectroscopy unit, e.g. wherein an intensity transmission through the amount of gas can directly be measured and e.g. compared to a reference intensity transmission through a reference medium. The absorption of light by the amount of gas can change as a function of frequency, such that an absorption spectrum of the amount of gas can be determined.

The non-destructive gas analysing unit can particularly be provided as a cavity ring-down spectroscopy (CRDS) unit. Cavity ring-down spectroscopy is an optical spectroscopic method, wherein the gas sample can be illuminated by light, e.g. provided by a laser. Since the gas sample absorbs light at specific wavelengths according to its specific gas composition, measuring the optical extinction or the decaying light intensity after turning off the light expediently allows to determine the concentration of the gas.

Direct absorption spectroscopy can for example be effective for determining a comparatively large concentration of a gas and/or its components, whereas CRDS can be effective for determining a comparatively small concentration of a gas and/or its components.

It is also possible, for measuring a gas concentration inside a container, to pump a certain volume of a gas sample out of the container and transfer it to a gas analyser. For example, the volume of gas sample required by a conventional gas analyser can take a significant portion of the total volume of the container. A FOUP can e.g. have a volume of 30 to 40 litres. A single gas analyser can e.g. require a gas sample of 4 to 8 litres for each measurement. It is possible, in order to balance the pressure inside the container when the gas sample is removed, to introduce clean air into the container. However, this introduction of clean air dilutes the gas concentration inside the container. A conventional gas concentration measurement of that kind with an open loop is therefore not repeatable. A result of a subsequent measurement does therefore not correspond to an initial gas concentration.

In contrast to that, the present invention allows to circle gas samples back to the container, such that the concentration of the gas sample and/or its components does not change. The measurement is therefore more precise and repeatable. The concentration of the gas and its components inside the container is therefore expediently maintained or kept constant. Different amounts of gas or different gas samples consecutively transferred from the container to the non-destructive gas analysing unit therefore have a constant concentration. Thus, by transferring the gas samples to the non-destructive gas analysing unit and afterwards back to the container, a closed loop for gas sample analysis can be provided.

The invention expediently allows to effectively recognise contamination within the container, e.g. such that this contamination can quickly and effectively be removed, e.g. in order to fulfil cleanliness requirements within the semiconductor industry.

The invention further relates to a system configured to perform an embodiment of a method according to the invention. The system comprises a non-destructive gas analysing unit, particularly a spectroscopy unit such as a cavity ring-down spectroscopy unit, configured to determine a concentration of at least one component of a gas, transferring means for transferring an amount of gas from the container to the non-destructive gas analysing unit, and returning means for returning the amount of gas from the non-destructive gas analysing unit to the container.

The invention further relates to a use of a non-destructive gas analysing unit, particularly a spectroscopy unit such as a cavity ring-down spectroscopy unit, for an embodiment of system according to the invention. Using a non-destructive gas analysing unit in that manner particularly allows to determine the concentration of a gas and/or its components within a wafer or reticle container, particularly a FOUP, FOSB, SMIF, RSP, etc., in an effective, precise, and repeatable way, expediently without changing or amending physical and/or chemical properties of the gas, particularly without changing or amending the concentration of the gas or its components.

Advantages and embodiments of the method, the system and the use of a non-destructive gas analysing unit according to the invention shall arise from the present description in an analogous manner.

According to an embodiment, the non-destructive gas analysing unit comprises a cavity, a radiation emitting unit, a detector unit, and an analysis unit. The amount of gas transferred from the container to the non-destructive gas analysing unit is stored in the cavity. A first radiation of a predetermined wavelength is emitted by means of the radiation emitting unit to the cavity for a first amount of time. After emitting the first radiation to the cavity for the first amount of time, a second radiation emitted from the cavity is detected by means of the detector unit over a second amount of time. The concentration of the amount of at least one component of a gas stored in the cavity is determined by means of the analysis unit in dependence of the detected second radiation. The first radiation can expediently be a laser light, e.g. a pulsed or a continuous wave laser light. The specific wavelength of the first radiation and the first amount of time, during which the first radiation is emitted into the cavity, can for example be determined in dependence of specific properties of the cavity itself and/or of the specific type of gas stored in the cavity to be analysed. For example, the wavelength can be adjusted to the specific gas type in order to generate a specific absorption spectrum. The amount of gas stored in the cavity expediently interacts with this first radiation in a specific manner. For example, the gas can absorb or scatter the first radiation. The radiation emitting unit is particularly turned off when the second radiation is detected. Thus, the first radiation is expediently not emitted any more, when the second radiation is detected. After turning off the radiation emitting unit, the amount of gas stored in the cavity reacts with the remaining radiation inside the cavity in a specific manner. Particularly, the second radiation can be detected over the second amount of time in a specific manner depending on the concentration of the amount of gas. The concentration of the gas can thus expediently be concluded by analysing the second radiation. The amount of gas can therefore precisely be determined without damaging the gas itself and without altering properties of the gas itself, especially without altering the concentration of the gas itself.

According to an embodiment, the non-destructive gas analysing unit further comprises at least two mirrors provided in the cavity. The first radiation emitted by the radiation emitting unit is reflected by means of these at least two mirrors such that the first radiation circulates or travels multiple times within the cavity. For example, two mirrors can be provided, expediently such that the first radiation can circulate bidirectionally multiple times between these two mirrors. It is also possible to provide more than two mirrors, e.g. such that the first radiation can circulate unidirectionally multiple times within the cavity by means of these mirrors. The cavity with its mirrors is expediently provided as an optical resonator, with a defined path along which the first radiation can repeatedly circulate. One of these mirrors can further be used for transferring an amount of the first radiation from the cavity as the second radiation towards the detector unit. This detected second radiation can for example be used to determine an intensity of the first radiation within the cavity, i.e. an intra-cavity light intensity.

According to an embodiment the analysis unit determines a decaying intensity of the second radiation during the second amount of time. The concentration of at least one component of the gas stored in the cavity is determined in dependence of the decaying intensity. After turning of the radiation emitting unit, the intensity of the first radiation remaining in the cavity, which especially still circulates within the cavity by means of the at least two mirrors, will decay over the second amount of time due to interaction of the first radiation with the gas stored in the cavity, e.g. due to absorption of the first radiation by means of the gas. Correspondingly, the intensity of the detected second radiation will also decay. The specific manner, in which the intensity of the second radiation decays, particularly depends on the concentration of the amount of gas stored in the cavity. Thus, by analysing the decaying intensity of the second radiation, the concentration of the of gas can expediently be concluded. For this purpose, the decaying intensity of the second radiation can e.g. be compared with a reference intensity profile for an empty or vacuumed cavity or for a cavity filled with a reference medium.

Particularly, the non-destructive gas analysing unit can be provided as a cavity ring-down spectroscopy unit configured for emitting the first radiation to the cavity, for circulating the first radiation within the cavity by means of the at least two mirrors, and for determining the concentration of the gas in dependence of the decaying intensity of the second radiation. By means of a CRDS unit of that kind, even small concentrations of gas can effectively be determined.

According to an embodiment, the amount of the gas is transferred from the container to the non-destructive gas analysing unit by means of a first pump unit and wherein the amount of the gas is returned from the non-destructive gas analysing unit to the container by means of a second pump unit. The transferring means therefore comprises the first pump unit and the returning means comprises the second pump unit. Therefore, the closed loop for gas sample analysis can easily be provided.

According to an embodiment, the concentration of at least one component of a gas in the container before transferring the amount of gas from the container to the non-destructive gas analysing unit and after returning the amount of gas from the non-destructive gas analysing unit to the container is maintained at a predetermined level. For example, this level can be set such that the concentrations inside the container before removing the amount of gas and after returning the amount of gas differ at most by 1 %, particularly at most by 0.5%, more particularly at most by 0.1%. Particularly, the level is predetermined such that the concentration in the container before removing and after returning the amount does not change at all. Therefore, the concentration of gas inside the container before and after the measurement can particularly be maintained and kept constant. The measurement therefore does not alter the concentration of the gas in the container, such that the measurement is precise and repeatable, especially over any longer or shorter period of time.

According to an embodiment, the steps of transferring the amount of gas from the container to the non-destructive gas analysing unit, determining the concentration of the at least one component of the amount of the gas by means of the non-destructive gas analysing unit, and returning the amount of the gas from the non-destructive gas analysing unit to the container are performed when, especially each time, a predetermined event occurs. The measurement of the gas concentration can therefore regularly be repeated. For example, the predetermined event can correspond to a movement of the container, e.g. such that the measurement is repeated each time the container is transported. Alternatively or additionally, the predetermined event can refer to the lapse of a predetermined time interval. Thus, the measurement can for example be repeated in regular, periodic time intervals. Since the measurement particularly does not change the gas concentration and is repeatable, a multitude of measurement values for the gas concentration in the container can be determined over time, which allows to evaluate the behaviour of the container over time.

According to an embodiment, the concentration of at least one component of the gas in the container is monitored over a predetermined monitoring period of time. The repeatable measurement expediently allows to evaluate and monitor a behaviour of the container over time. For example, a degassing or outgassing behaviour of the container can be monitored over time. This is for example advantageous in connection with containers which are new, or have just been cleaned, and are still subject to outgassing effects. After such events, outgassing initially occurs at a relatively high level, and diminishes over time, until it reaches an essentially constant level. Based on the invention, arrival at a constant and/or an acceptable level of outgassing can be more easily monitored than with previous solutions. Based on the invention, for example, also a tightness of the container and/or a state of a gasket of the container can be monitored. For example, by monitoring the gas concentration, wear of the container gasket can be monitored over the container lifetime. For example, when monitoring the gas concentration during a production procedure of the container, it can be evaluated when the tightness of the container fulfils predetermined requirements such that the container can be used for storing wafers or reticles.

The concentration of the gas in the container can particularly be monitored over the predetermined period of time by means of the concentration of the amount of gas repeatedly determined when the predetermined event occurs. The event can especially be predetermined such that a reliable monitoring can be performed. For example, time intervals for repeating the measurement can be predetermined such that a trend of the gas concentration can reliably be monitored.

Further advantages and embodiments of the invention may be derived from the appended drawings and the description.

The invention is schematically illustrated in the drawings with reference to specific embodiments and, in the following, is described with reference to the drawings.

### Brief description of the drawings

- Figure 1: schematically shows a system for determining a concentration of a gas in a container according to the prior art.
- Figure 2: schematically shows an embodiment of a system for determining a concentration of at least one component of a gas in a container according to the present invention, which is configured to perform an embodiment of a method according to the present invention.
- Figure 3: schematically shows a non-destructive gas analysing unit, which can be used in a system for determining a concentration of at least one component of a gas in a container according to an embodiment of the present invention.

### Exemplary embodiment(s) of the invention

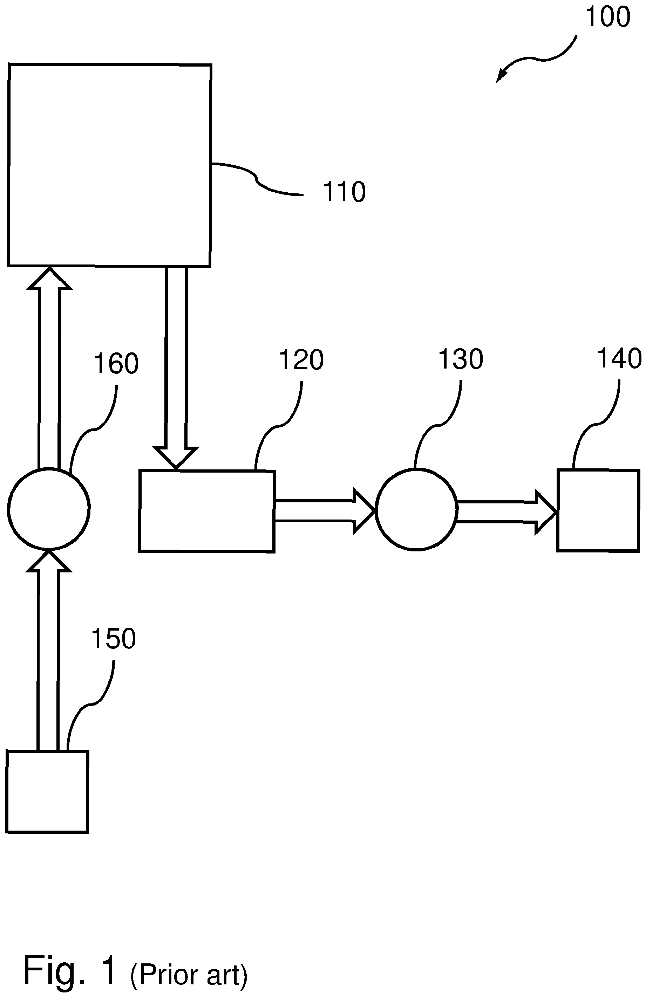

Figure 1 schematically a system 100 for determining a concentration of a gas in a container 110 according to the prior art.

The container 110 can for example be a front opening unified pod (FOUPs), a front opening shipping box (FOSB), a standard mechanical interface (SMIF), a reticle SMIF pod (RSP), etc.

An amount of gas or a gas sample is removed from the container 110 and transferred to a gas analysing unit 120 by means of a first pump 130 for determining the concentration of the gas sample. After this determination, the gas sample is transferred from the gas analysing unit 120 by means of the first pump 130 to an exhaust 140.

In order to balance the pressure inside the container 110, clean air is introduced from a corresponding source 150 of clean air to the container 110 by means of a second pump 160. However, this introduction of clean air dilutes the gas concentration inside the container 110. The measurement of the gas concentration of that kind with an open loop is therefore not repeatable.

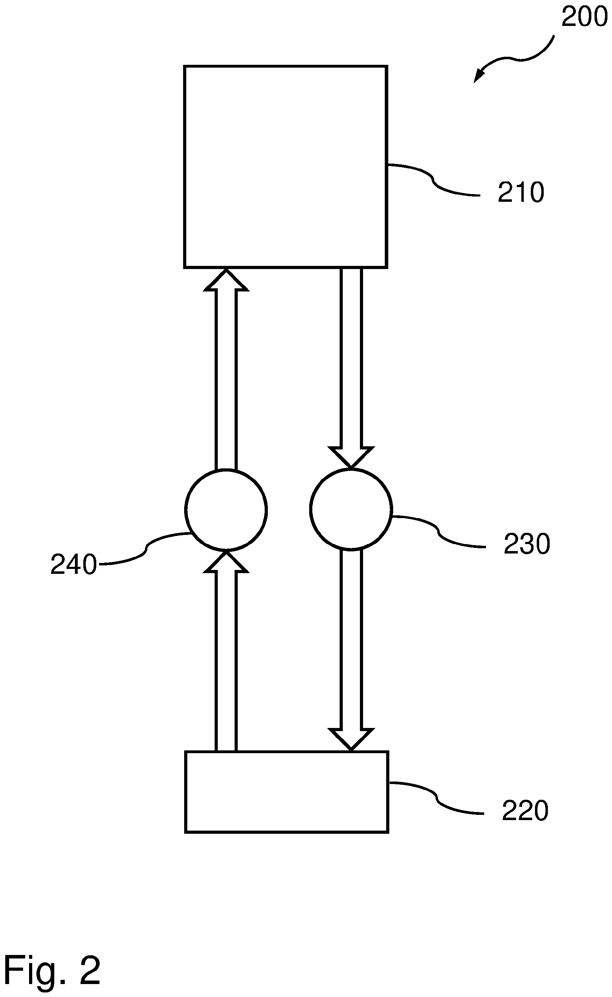

Figure 2 schematically shows an embodiment of a system 200 for determining a concentration of at least one component of a gas in a container 210 according to the present invention, wherein the system 200 is configured to perform an embodiment of a method according to the present invention.

The container 210 can for example also be a front opening unified pod (FOUP), a front opening shipping box (FOSB), a standard mechanical interface (SMIF), a reticle SMIF pod (RSP), etc.

The system 200 comprises a non-destructive gas analysing unit 220, a transferring means 230, e.g. a first pump, and a returning means, e.g. a second pump 240. An amount of gas or a gas sample is transferred from the container 210 to the non-destructive gas analysing unit 220 by means of the first pump 230. A concentration of the amount of the gas is determined by means of the non-destructive gas analysing unit 220. The amount of the gas is then returned from the non-destructive gas analysing unit 220 back to the container 210 by means of the second pump 240.

The system 200 therefore allows to circle the gas samples back to the container 210 via a closed loop, such that the concentration of the gas sample does not change. The concentration of the gas inside the container 210 is therefore maintained or kept constant. The determination of the gas concentration by means of the non-destructive gas analysing unit 220 is therefore precise and repeatable.

The measurement of the gas concentration is for example performed such that the concentration of the gas in the container 210 before transferring the amount of gas from to the non-destructive gas analysing unit 220 and after returning the amount of gas back to the container 210 is maintained at a predetermined level, e.g. such that the concentrations inside the container 210 before removing and after returning the amount of gas differ by less than 0.1 %.

The measurement of the gas concentration is for example repeated when a predetermined event occurs, e.g. when a predetermined time interval lapses. The measurement can thus be, for example, repeated in regular, periodic time intervals. This way, a multitude of measurement values for the gas concentration is determined overtime. By means of these multiple measurement values, the concentration of the gas in the container 210 can be monitored over a predetermined monitoring period of time. This way, for example, a degassing or outgassing behaviour of the container 210, a tightness of the container 210, and a state of a gasket of the container 210 can be monitored over time.

The non-destructive gas analysing unit 220 is particularly provided as a spectroscopy unit, wherein a radiation, e.g. light, can be emitted towards the amount of gas, which has been removed from the container. It can be evaluated how the amount of gas interacts with this radiation, e.g. how the amount of gas absorbs or scatters the radiation. This specific interaction particularly depends on the specific concentration of the amount of gas such that this concentration can be determined in dependence of the evaluated interaction pattern.

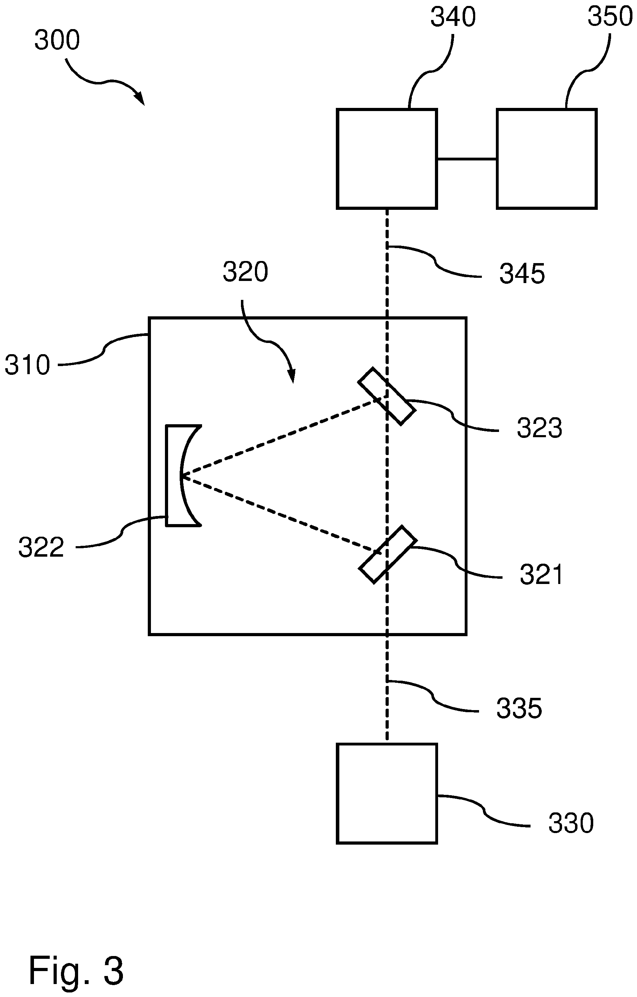

The non-destructive gas analysing unit 220 can for example be provided as a direct absorption spectroscopy unit, wherein an intensity transmission through the amount of gas can directly be measured and compared to a reference intensity transmission through a reference medium. The non-destructive gas analysing unit 220 can also be provided as a cavity ring-down spectroscopy (CRDS) unit, as shall hereafter be explained with reference to Figure 3.

Figure 3 schematically shows a cavity ring-down spectroscopy (CRDS) unit 300, which can be used as the non-destructive gas analysing unit 220 of the system 200 according to an embodiment of the present invention.

The CRDS unit 300 comprises a cavity 310 configured to store the amount of gas transferred from the container 210 to the CRDS unit 300 by means of the first pump 230.

The CRDS unit 300 further comprises a radiation emitting unit 330 configured to emit first radiation 335 of a predetermined wavelength to the cavity 310 for a first amount of time. The first radiation 335 can for example be a laser light, e.g. a pulsed or a continuous wave laser light.

At least two mirrors 321, 322, 323 are provided in the cavity 310 configured to reflect the laser light 335 emitted by the radiation emitting unit 330 such that the laser light 335 circulates multiple times within the cavity 310. These mirrors 321,322, 323 in the cavity 310 are expediently provided as an optical resonator 320. In the example shown in Figure 3, three mirrors 321, 322, 323 are provided. However, it is also possible to provide only two mirrors or more than three mirrors.

The CRDS unit 300 further comprises a detector unit 340 configured to detect second radiation 345 emitted from the cavity 310. For example, mirror 323 is further configured for transferring an amount of the laser light circulating with in the cavity 310 as this second radiation 345 towards the detector unit 340. This detected second radiation 345 can for example be used to determine an intensity of the laser light circulating within the cavity 310. The second radiation 345 is determined by means of the detector unit 340 over a second amount of time after emitting the first radiation 335 to the cavity 310 for the first amount of time, i.e. after turning off the radiation emitting unit 330.

The CRDS unit 300 further comprises an analysis unit 350 configured to determine a concentration of the amount of gas stored in the cavity 310 in dependence of the second radiation 345 detected by the detector unit 340. Particularly, the analysis unit 350 determines a decaying intensity of the second radiation 345 during the second amount of time, which corresponds to a decaying intensity of the first laser light 335 circulating inside the cavity 310. The analysis unit 350 determines the concentration of the gas stored in the cavity 310 in dependence of this decaying intensity of the detected second radiation 345.

After turning of the radiation emitting unit 330, the intensity of the first laser light 335 remaining in the cavity 310 and still circulating within the cavity 310 by means of the mirrors 321, 322, 323 will decay over the second amount of time due to interaction with the gas in the cavity 310. Correspondingly, the intensity of the detected second radiation 345 will also decay. The specific manner, in which this intensity decays, depend on the concentration of the amount of gas in the cavity 310. For example, by comparing the determined decaying intensity with a reference intensity profile, e.g. for an empty or vacuumed cavity or for a cavity filled with a reference medium, the concentration of the gas in the cavity 310 can be ascertained. After determining the gas concentration, the amount of gas in the cavity 310 is returned back to the container 210 by means of the second pump 240.

As a non-destructive gas analysing unit such as the CRDS unit 300 does not change the concentration and other physical and chemical properties of the gas, using a non-destructive gas analysing unit allows to determine the gas concentration of the wafer or reticle container 210 like a FOUP, FOSB, SMIF, RSP, etc., in an effective, precise, and repeatable manner.

## Claims

1. Method for determining a concentration of at least one component of a gas, especially of the gas as a whole, in a container (210) adapted and configured to hold wafers or reticles, comprising the steps of:
transferring an amount of gas from the container (210) to a non-destructive gas analysing unit (220, 300);
determining a concentration of at the least one component, especially the gas as a whole, within the amount of gas by means of the non-destructive gas analysing unit (220, 300), particularly by means of a spectroscopy unit such as a cavity ring-down spectroscopy unit or a direct absorption spectroscopy unit; and
returning the amount of gas from the non-destructive gas analysing unit (220, 300) to the container (210).

2. The method according to claim 1, wherein the step of determining the concentration of at least one component within the amount of gas by means of the non-destructive gas analysing unit (220, 300) comprises:
storing the amount of gas in a cavity (310);
emitting a first radiation (335) of a predetermined wavelength to the cavity (310) for a first amount of time;
detecting a second radiation (345) emitted from the cavity (310) over a second amount of time after the emitting of the first radiation (335) to the cavity (310) for the first amount of time; and
determining the concentration of the amount of gas stored in the cavity (310) in dependence of the detected second radiation.

3. The method according to claim 2, further comprising:
reflecting the first radiation (310) in the cavity (310) by means of at least two mirrors (321, 322, 323) such that the first radiation (335) circulates multiple times within the cavity (310).

4. The method according to claim 2 or 3, wherein the step of determining the concentration of at least one component of the amount of gas comprises:
determining a decaying intensity of the second radiation (345) during the second amount of time; and
determining the concentration at least one component of the gas stored in the cavity (310) in dependence of the decaying intensity.

5. The method according to any one of the preceding claims, wherein the amount of gas is transferred from the container (210) to the non-destructive gas analysing unit (220, 300) by means of a first pump unit (230) and wherein the amount of gas is returned from the non-destructive gas analysing unit (220, 300) to the container (210) by means of a second pump unit (240).

6. The method according to any one of the preceding claims, further comprising:
maintaining the concentration of the gas in the container before transferring the amount of gas from the container (210) to the non-destructive gas analysing unit (220, 300) and after returning the amount of gas from the non-destructive gas analysing unit (220, 300) to the container (210) at a predetermined level.

7. The method according to any one of the preceding claims, further comprising:
performing the steps of transferring the amount of gas from the container (210) to the non-destructive gas analysing unit (220, 300), determining the concentration of the amount of gas by means of the non-destructive gas analysing unit (220, 300), and returning the amount of gas from the non-destructive gas analysing unit (220, 300) to the container (210) when, especially each time, a predetermined event occurs.

8. The method according to any one of the preceding claims, further comprising:
monitoring the concentration of the gas in the container (210) over a predetermined period of time, especially at regular or irregular intervals, especially by means of the concentration of the amount of gas repeatedly determined when the predetermined event occurs.

9. System (200) for determining a concentration of at least one component of a gas, especially of the gas as a whole, in a container (210) adapted and configured to hold wafers or reticles, wherein the system is configured to perform a method according to any one of the preceding claims, comprising:
a non-destructive gas analysing unit (220, 300), particularly a spectroscopy unit such as a cavity ring-down spectroscopy unit or a direct absorption spectroscopy unit, configured to determine a concentration of at least one component of a gas, especially of the gas as a whole;
transferring means (230) for transferring an amount of gas from the container (210) to the non-destructive gas analysing unit (220, 300); and
returning means (240) for returning the amount of gas from the non-destructive gas analysing unit (220, 300) to the container (210).

10. The system (200) according to claim 9, wherein the non-destructive gas analysing unit (220, 300) comprises:
a cavity (310) configured to store the amount of gas;
a radiation emitting unit (330) configured to emit first radiation (335) of a predetermined wavelength to the cavity (310) for a first amount of time;
a detector unit (340) configured to detect second radiation (345) emitted from the cavity (310) over a second amount of time after emitting the first radiation (335) to the cavity (310) for the first amount of time; and
an analysis unit (350) configured to determine a concentration of the amount of gas stored in the cavity (310) in dependence of the second radiation (345) detected by the detector unit (340).

11. The system (200) according to claim 10, wherein the non-destructive gas analysing unit (220, 300) further comprises:
at least two mirrors (321, 322, 323) provided in the cavity (310) configured to reflect the first radiation (335) emitted by the radiation emitting unit (330) such that the first radiation (335) circulates multiple times within the cavity (310).

12. The system (200) according to claim 10 or 11, wherein the analysis unit (350) is configured to determine a decaying intensity of the second radiation (345) during the second amount of time and to determine the concentration of the gas stored in the cavity (310) in dependence of the decaying intensity.

13. The system according to claim 10, wherein the transferring means (230) comprises a first pump unit and wherein the returning means (240) comprises a second pump unit.

14. Use of a non-destructive gas analysing unit (220, 300), particularly a spectroscopy unit such as a cavity ring-down spectroscopy unit or a direct absorption spectroscopy unit, for a system (200) according to any one of the claims 9 to 13.
